# EUROPEAN PATENT SPECIFICATION

(11) **EP 0 452 778 B1**
(45) Date of publication and mention of the grant of the patent: **15.03.1995**
(21) Application number: 91105628.1
(22) Date of filing: 09.04.1991
(51) Int. Cl.: F16J 12/00

(54) **Pressure vacuum vessel and method of manufacture**
Vakuumdruckbehälter und sein Herstellungsverfahren
Récipient de pression sous vide et son procédé de fabrication

(30) Priority: 20.04.1990 US 511431
(43) Date of publication of application: 23.10.1991
(73) Proprietor: APPLIED MATERIALS, INC., Santa Clara, California 95052-8039 (US)
(72) Inventor: Tepman, Avi, Cupertino, California 95014 (US)
(74) Representative: Kahler, Kurt, Dipl.-Ing.

(56) References cited:
- FR-A- 661 226

## Description

The present invention relates generally to leak-proof vessels according to claim 1, to such vessels which are subject to a pressure differential between the interior and the ambient and, in particular, to vacuum chambers used for processing semiconductors circuits and to a method of forming such a vessel according to claim 5.

### Background of the Invention

We use the terms "junction", "three-weld junction" and "multiple-weld junction" interchangeably.

To my knowledge, there are available presently two feasible techniques for fabricating pressure or vacuum vessels such as the vacuum chambers which are used for processing semiconductor circuits: first, hogging or sculpting the vessel from a solid block of metal and, second, welding together appropriately patterned sheet metal. Of the two techniques, sheet metal fabrication typically requires less time and expense and is the presently preferred approach for fabricating such vessels.

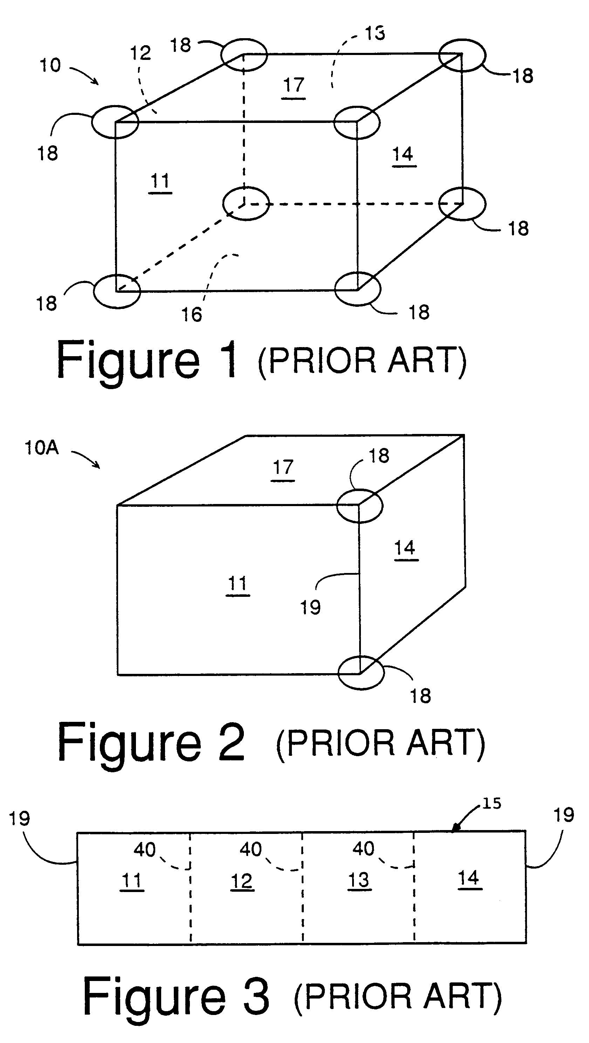

However, the use of sheet metal fabrication techniques requires the formation of multiple-weld junctions, which are susceptible of leakage, especially when tested after welding, and are nearly impossible to repair. This problem is illustrated in FIG. 1, which depicts an exemplary rectangular semiconductor vacuum vessel or chamber 10 that has been fabricated from sheet metal. The rectangular vessel 10 comprises four sidewalls 11, 12, 13 and 14 and top and bottom walls 16 and 17. If vessel 10 is assembled from six separate pieces of sheet metal, eight separate three-weld junctions 18 are formed, each of which is more susceptible to leaks than a weld between only two adjoining surfaces.

Referring to the vessel 10A shown schematically in FIG. 2, to reduce the number of three-weld junctions, several of the walls can be formed from a single sheet. For example, the four walls 11, 12, 13 and 14 can be bent from a single sheet 15 shown in FIG. 3 (sheet 15 is not to scale). This structure 10A requires simple two-edge welds along the top and bottom surfaces and along the end edges 19-19 and thus requires only two of the three-weld junctions 18-18, one each where the edges 19-19 are joined together and to the top and bottom walls. Thus, while the vessel 10A would reduce the number of multiple-weld junctions vis-a-vis vessel 10, it would not eliminate them. Furthermore, the three bends are very difficult to make. Using regular bending machines, there would be no way to remove the closed structure which results from the three bends and, thus, special machines and techniques would be required.

In reducing the number of multiple-weld junctions, the above structure 10A does not eliminate the problem of fixing leaks at junctions. While any weld may leak, a continuous weld can be ground and rewelded, but it is almost impossible to grind and reweld a junction. Thus, it is usually necessary to discard rather than repair leaking vessels such as 10 and 10A. Such vessels, especially those used for applications such as semiconductor integrated circuit fabrication, are expensive and it is highly desirable to have a fabrication technique which is less subject to leaks and which can be repaired easily.

FR-A-661226, from which the invention starts, discloses a container formed by fitting together two generally U-shaped wall portions and joining them along mating edges. One of the wall portions is provided with a bent-off flange extending all around its edge. The edge of one of the wall portions is welded with the flange.

It is the object of the present invention to provide a vacuum pressure vessel and a method for fabricating such vessels which do not employ multiple weld junctions and needs no flange forming for connecting the individual wall portions together.

The vacuum pump vessel according to the invention is characterized in claim 1 and a method for fabricating such a vessel is characterized in claim 5.

Improvement features of the invention are defined in the dependent claims.

### Brief Description of the Drawings

The above and other aspects of the present invention are described in detail with respect to the drawings, in which:
FIGS. 1 and 2 depict conventional prior art vessels, each of which includes a number of multiple-edge (multiple-weld) junctions;
FIG. 3 depicts a strip used for forming four walls of the vessel of FIG. 2;
FIGS. 4 and 5 are, respectively, a simplified exploded perspective view and a perspective view of a vessel embodying my present invention, which contains no multiple edge or multiple weld junctions;
FIG. 6 depicts an alternative embodiment of a vessel made according to my invention; and
FIG. 7 illustrates use of my vessels in a small footprint, multiple chamber IC processing system.

### Detailed Description of the Preferred Embodiment(s)

### First Embodiment

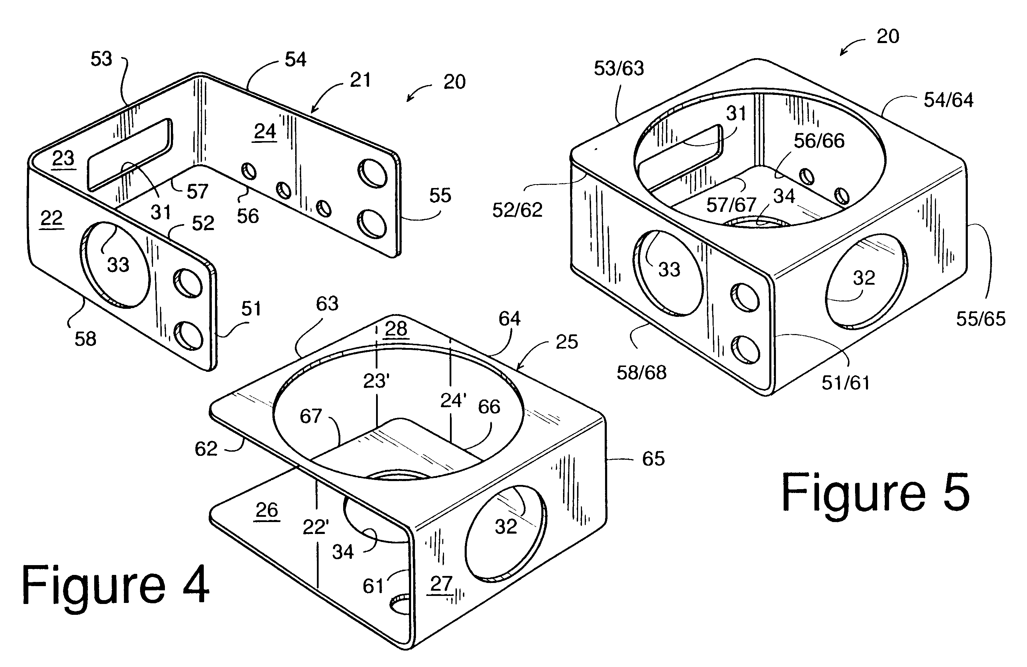

Referring now to FIGS. 4 and 5, there is disclosed a vessel 20 which is formed according to, and embodies, my present invention. The vessel 20 comprises a pair of mating sheets 21 and 25. Each sheet is bent or otherwise formed into an arcuate, open-ended configuration, illustratively a generally U-shaped configuration. For example, exemplary sheet 21 comprises three walls 22, 23 and 24 (walls 22 and 24 form the legs of the U, while wall 23 forms the base), while sheet 25 comprises three walls 26, 27 and 28 (walls 26 and 28 form the legs of the U, while wall 27 forms the base). As is most evident from the exploded view shown in FIG. 4, the cooperatively formed, mating U-shaped members 21 and 25 are formed so that the walls (such as walls 22, 23 and 24 of member 21) enclose corresponding "open" spaces or openings between the walls of the other U-member (spaces 22', 23' and 24' of U-member 25). In effect, the two illustrated mating members 21 and 25 are U-shaped members which are rotated 90° relative to one another and are configured to enclose the open sides of one another.

As is perhaps best illustrated in FIG. 5, when the mating sheets 21 and 25 are fitted together, they mate along six edge junctions, each of which is formed by only two sheet edges. That is, edge 51 of sheet 21 mates with edge 61 of sheet 25, edges 52 and 62 form a second junction and the corresponding edges 53/63, 54/64, 55/65, 56/66, 57/67 an 58/68 all form two-edge junctions. Thus, when the two mated sheets are permanently joined together as by welding, the weld seams 51/61...58/68 all are two-edge junctions. (Please note, for convenience the welds are designated by the same numbers as the mating edges.) That is, there are no three-edge junctions or multiple edge junctions. Also, relatively few welds are required. In addition, the welding can be implemented as a continuous, single weld starting, for example, from edge 51/61 and wrapping around the vessel to and terminating at 58/68.

FIGS. 4 and 5 also illustrate various types of apertures or holes which may be formed in the vessel sides to adapt the vessel to semiconductor fabrication or other use. For example, apertures 31, 32 and 33 are fitted with a slit valve, a gate valve and a view port, respectively, and 34 is a mechanical feed-through. Other apertures provide access for process gas, mount pyrometers, pressure gauges, etc. The depicted apertures are shown by way of example only and are not limiting. Quite obviously, my vessel may be used in applications involving fewer or more apertures and associated fittings.

### Method of Making

As suggested above, my vessel is conveniently formed by bending or otherwise forming the U-shaped sheets 21 and 25 into their arcuate configuration, fitting the sheets together and then welding or otherwise joining the sheets along the mating, non-multiple-edge, junctions. Any apertures can be cut or stamped before the sheets are formed or joined or can be cut after the sheets are joined. Of course, any required valves, hardware, viewing ports, or other structural features or supports will be added as required by those of usual skill in the art.

### Additional Embodiments

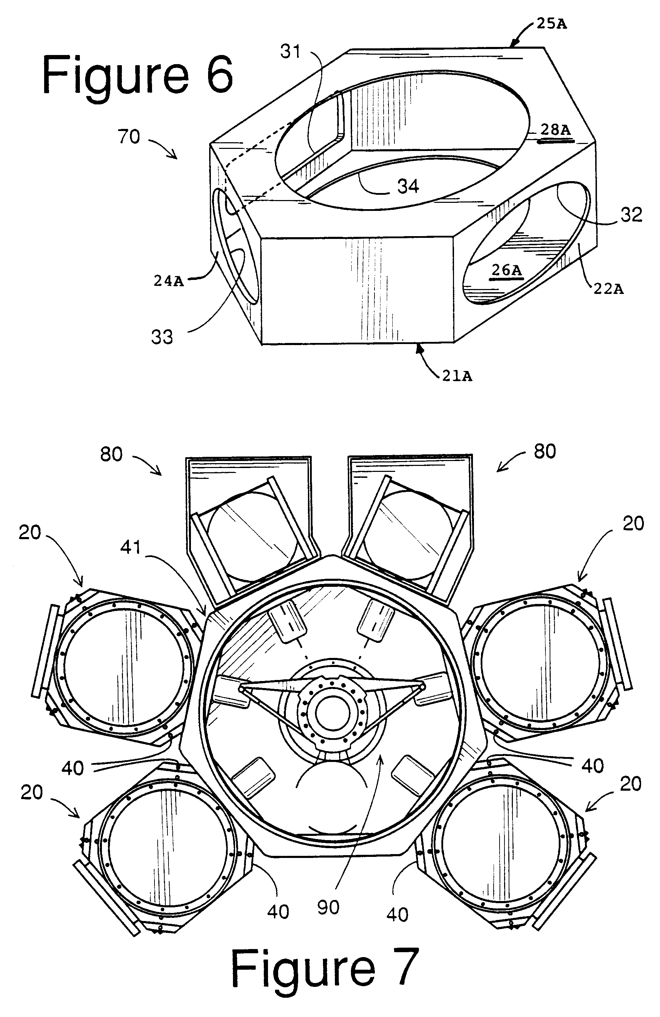

FIG. 6 defines a second embodiment 70 of my vessel which incorporates all the features and advantages of the vessel 20. Vessel 70 differs from vessel 20 in that the two opposite sides 26A and 28A of the U-shaped sheet 25A comprise non-rectangular polygons while the mating sides 22A and 24A of the other U-shaped sheet 21A are bent or otherwise formed into the peripheral configuration of polygons 26A and 28A, to wrap around or wrap within the perimeter of polygon 26A and 28A.

FIG. 7 depicts still another vessel configuration 80 which can be formed using my invention. In this case, each chamber 80 includes skewed six-sided top and bottom walls which accommodate the angled path of entry of robot 90 into the chamber.

### Summary of Certain Advantages

Thus, I have described two embodiments of my vessel which are relatively easily formed, have a relatively reduced number of two-edge welds, and can be formed without multiple-edge (three or more) junctions. Where leaks develop, they are detected and repaired more easily along two-edge welds than along multiple-edge junctions. Thus, for vessels which are fabricated according to my invention, it is anticipated that the typical remedy for leaks will be to find and repair the leak rather than to discard and replace an expensive pressure/vacuum vessel.

Semiconductor and other vacuum processing technology is moving toward automated, robotic, multiple chamber systems. It is desirable to minimize the footprint of such systems, that is, to configure the system such that the space occupied by the multiple processing chambers and the single or multiple loadlock chambers is as small as possible. My vessel design assists in achieving such design objectives because the non-joined edges (i.e., the bent edges 40, FIG. 3) can be formed as rounded edges. Referring to FIG. 7, there is shown a seven-sided loadlock or transfer chamber 41 having vessels 20 mounted on the walls thereof. The rounded adjacent edges on the vessels permit the vessels to be mounted closer together and permit the overall structure to be smaller than would be possible if square edges or sharp edges were used. In addition, the orientation of the chamber can be selected to maximize structural strength. Also, the continuous seam 51/61 - 58/68 is especially suited for automated continuous welding, i.e., for joining by a single continuous weld.

While welded sheet metal is described here, those of usual skill in the art will apply other materials and joining techniques available today and as they become available, e.g., plastic materials, fiberglass, and composite materials and associated composite-joining techniques such as brazing, and epoxy-glue, to form various pressure and vacuum tanks according to my invention.

Thus, having described preferred and alternative embodiments of my present invention, those of usual skill in the art will readily derive additional embodiments and modifications thereof which are within the scope thereof and within the scope of the appended claims.

## Claims

1. A vacuum pump pressure vessel (20; 70) comprising:
a pair of mating plane metal sheets (21, 25; 21A, 25A) each formed in a generally U-shaped three-sided configuration for cooperatively fitting together along mating edges (51/61 to 58/68) to form an enclosed chamber of polygonal cross-section, said sheets fitting together, their junctions being not multiple edge junctions; and
one or more welds (51/61 to 58/68) joining the sheets together along the junctions.

2. The vacuum pump pressure vessel of claim 1, wherein the sheets are provided with apertures (31 to 34) for attaching fittings, valves or the like, or serving as a feed through.

3. The vacuum pump pressure vessel of claim 1 or 2, wherein two of the opposite walls of one (25A) of the U-shaped sheets (21A, 25A) are non-rectangular polygons (26A, 28A) and the remaining walls (e.g. 22A, 24A) of the two sheets are rectangles.

4. The vacuum pump pressure vessel of claim 1, 2, or 3, wherein the joining means is a continuous weld.

5. A method of forming a vacuum pump pressure vessel (20; 70) according to any of the preceding claims, comprising:
- providing a pair of sheets (21, 25; 21A, 25A);
- stamping or cutting apertures (31 to 34) in at least one of said sheets;
- forming each of a pair of sheets (21, 25; 21A, 25A) into a generally U-shaped three-sided configuration adapted for mating with the other of the pair, so that the walls mate together without multiple edge junctions; and
- joining the sheets together along the junctions by welding.

6. The method of claim 5,
wherein joining the sheets (21, 25; 21A, 25A) comprises a single continuous welding step.

7. The method of claim 5,
wherein providing the sheets (21, 25; 21A, 25A) comprises regularly bending sheet metal.

8. The method of claim 7,
wherein joining the sheets (21, 25; 21A, 25A) comprises welding edges of the sheets.

## Patentansprüche

1. Ein auf Vakuum pumpbarer Druckbehälter (20; 70) mit:
einem Paar zusammenpassender, ebener Metallplatten (21, 25; 21A, 25A), die jeweils in einer im allgemeinen U-förmigen, dreiseitigen Gestalt zum gemeinsamen Zusammenfügen längs zusammenpassender Kanten (51/61 bis 58/68) ausgebildet sind, so daß eine eingeschlossene Kammer mit einem polygonalen Querschnitt ausgebildet ist, wobei die Platten so zusammenpassen, daß ihre Verbindungsstellen keine Mehrkant-Verbindungsstellen sind; und
einer oder mehreren Schweißnähten (51/61 bis 58/68), die die Platten längs der Verbindungsstellen miteinander verbinden.

2. Der auf Vakuum pumpbare Druckbehälter nach Anspruch 1,
wobei die Platten mit Öffnungen (31 bis 34) versehen sind, an denen Anschlußstücke, Ventile oder dergleichen befestigbar sind oder die als Durchführung dienen.

3. Der auf Vakuum pumpbare Druckbehälter nach Anspruch 1 oder 2,
wobei zwei der gegenüberliegenden Wände von einer (25A) der U-förmigen Platten (21A, 25A) nichtrechteckige Polygone (26A, 28A) und die übrigen Wände (z. B. 22A, 24A) der beiden Platten Rechtecke ausbilden.

4. Der auf Vakuum pumpbare Druckbehälter nach Anspruch 1, 2 oder 3,
wobei die verbindende Einrichtung eine kontinuierliche Schweißnaht ist.

5. Ein Verfahren zum Ausbilden eines auf Vakuum pumpbaren Druckbehälters (20; 70) nach einem der vorhergehenden Ansprüche mit:
- dem Vorsehen eines Paares aus Platten (21, 25; 21A, 25A);
- dem Stanzen oder Schneiden von Öffnungen (31 bis 34) in zumindest eine der Platten;
- dem Ausbilden jeder Platte von einem Paar aus Platten (21, 25; 21A, 25A) zu einer im allgemeinen U-förmigen, dreiseitigen Gestalt, die mit der anderen des Paares zusammenpaßt, so daß die Wände ohne Mehrkant-Verbindungsstellen zusammenpassen; und
- dem Zusammenfügen der Platten längs der Verbindungsstellen mittels Schweißens.

6. Das Verfahren nach Anspruch 5,
wobei das Verbinden der Platten (21, 25; 21A, 25A) einen einzigen, kontinuierlichen Schweißschritt aufweist.

7. Das Verfahren nach Anspruch 5,
wobei das Vorsehen der Platten (21, 25; 21A, 25A) ein übliches Biegen von Metallplatten aufweist.

8. Das Verfahren nach Anspruch 7,
wobei das Verbinden der Platten (21, 25; 21A, 25A) das Zusammenschweißen der Kanten der Platten aufweist.

## Revendications

1. Enceinte à pression de pompe à vide (20 ; 70) comprenant :
une paire de tôles planes appariées (21, 25 ; 21A, 25A) formées chacune en une configuration à trois cotés généralement en forme de U afin de s'assembler de manière coopérante le long de bords appariés (51/61 à 58/68) afin de former une enceinte close de section transversale polygonale, lesdites tôles se correspondant, leurs joints n'étant pas des joints à bords multiples, et
une ou plusieurs soudures (51/61 à 58/68) réunissant les tôles le long des joints.

2. Enceinte à pression de pompe à vide selon la revendication 1, dans laquelle les tôles sont munies d'ouvertures (31 à 34) permettant de fixer des accessoires, vannes ou analogues, ou servant de passage d'amenée.

3. Enceinte à pression de pompe à vide selon la revendication 1 ou 2, dans laquelle deux des parois opposées de l'une (25A) des tôles en forme de U (21A, 25A) sont des polygones non rectangles (26A, 28A) et les parois restantes (par exemple 22A, 24A) des deux tôles sont des rectangles.

4. Enceinte à pression de pompe à vide selon la revendication 1, 2 ou 3, dans laquelle le moyen de liaison est une soudure continue.

5. Procédé de formation d'une enceinte à pression de pompe à vide (20 ; 70) selon l'une quelconque des revendications précédentes, comprenant les étapes consistant à :
- procurer une paire de tôles (21, 25 ; 21A, 25A),
- emboutir ou découper des ouvertures (31 à 34) dans l'une au moins desdites tôles,
- former chacune d'une paire de tôles (21, 25 ; 21A, 25A) en une configuration à trois cotés généralement en forme de U adaptée pour s'accoupler à l'autre de la paire, de sorte que les parois s'accouplent sans joints à bords multiples, et
- réunir les tôles le long des joints par soudage.

6. Procédé selon la revendication 5, dans lequel la réunion des tôles (21, 25 ; 21A, 25A) comprend une étape de soudage continu unique.

7. Procédé selon la revendication 5, dans lequel l'étape consistant à procurer les tôles (21, 25 ; 21A, 25A) comprend l'étape consistant à plier de la tôle de manière habituelle.

8. Procédé selon la revendication 7, dans lequel la réunion des tôles (21, 25 ; 21A, 25A) comprend l'étape consistant à souder les bords des tôles.
